Europäisches Patentamt

European Patent Office

Office européen des brevets

(11) Numéro de publication : **0 448 419 A1**

(19)

# (12) DEMANDE DE BREVET EUROPEEN

(21) Numéro de dépôt : **91400359.5**

(22) Date de dépôt : **13.02.91**

(51) Int. Cl.⁵ : **G01R 27/14, G01R 1/04**

(30) Priorité : **27.02.90 FR 9002419**

(43) Date de publication de la demande :
**25.09.91 Bulletin 91/39**

(84) Etats contractants désignés :
**AT BE CH DE DK ES FR GB GR IT LI LU NL SE**

(71) Demandeur : **ATOCHEM**
**4 & 8, Cours Michelet La Défense 10**
**F-92800 Puteaux (FR)**

(72) Inventeur : **Lieux, Georges**
**22, allée Charles Baudelaire**
**Le Mas Saint-Jean, F-13500 Martigues (FR)**
Inventeur : **Aubert, Jean**
**Rue du Moulin Roux**
**F-13920 Saint-Mitre les Remparts (FR)**

(54) **Dispositif pour mesurer la qualité du contact entre deux éléments conducteurs de l'électricité.**

(57) La Présente invention concerne un dispositif de mesure du contact entre deux conducteurs $\underline{A}$ et $\underline{B}$, caractérisé en ce qu'il est constitué :

a) d'un châssis en matériau isolant électrique ;

b) de deux pinces conductrices solidaires du châssis équipées de moyens pour se fixer chacune sur un de ces conducteurs $\underline{A}$ et $\underline{B}$, chaque pince étant reliée à l'une des bornes d'un générateur de courant ;

c) de deux pointeaux métalliques solidaires du châssis et ayant des moyens pour se mettre en contact avec chacun des deux conducteurs $\underline{A}$ et $\underline{B}$, mais à l'intérieur de l'ensemble formé par $\underline{A}$ et $\underline{B}$ compris entre les liaisons des pinces $\underline{b}$ avec $\underline{A}$ et $\underline{B}$.

EP 0 448 419 A1

# DISPOSITIF POUR MESURER LA QUALITE DU CONTACT ENTRE DEUX ELEMENTS CONDUCTEURS DE L'ELECTRICITE

La présente invention concerne un dispositif pour mesurer la qualité du contact entre deux éléments conducteurs de l'électricité.

Elle est plus particulièrement utile pour mesurer rapidement la qualité du contact électrique entre des assemblages en différents métaux.

Il est décrit dans le KIRK OTHMER (ENCYCLOPEDIA OF CHEMICAL TECHNOLOGY, Vol. 1, pages 806 et plus, 3ème édition, John Wiley) la production industrielle du chlore et de la soude. Dans le procédé à mercure les anodes sont des réseaux de fils en titane pouvant aller jusqu'à un mètre sur trois mètres renforcées par des barres et des traverses en titane soudées sur ces réseaux pour les maintenir parfaitement plans. Sur ces traverses, on visse des barres de cuivre qui assurent la liaison avec le reste du circuit électrique de l'électrolyse et qui permettent aussi de maintenir ces anodes dans la solution de chlorure de sodium à quelques millimètres au-dessus du mercure.

Si la qualité du contact entre la barre de cuivre et la traverse en titane n'est pas bonne, il se produit un échauffement par effet Joule pouvant même provoquer la rupture mécanique de la liaison cuivre/titane par fusion des métaux.

La liaison entre les barres de cuivre et les traverses en titane est noyée dans la solution de chlorure de sodium ; de plus au-dessus de cette solution se trouve le chlore qui s'est formé à la surface des anodes en titane. Il est donc impossible d'accéder à la liaison cuivre/titane.

C'est pourquoi il est très important d'être sûr de la qualité du contact cuivre/titane avant de monter les anodes dans les cellules d'électrolyse, lorsque la cellule d'électrolyse est en fonctionnement.

La demanderesse a mis au point un dispositif qui permet de vérifier la qualité du contact entre deux éléments conducteurs de l'électricité. Un autre but de l'invention est aussi de vérifier la qualité du contact avec une intensité semblable à celle qui va traverser le contact pendant le fonctionnement réel.

Le dispositif de mesure de contact entre deux conducteurs $A$ et $B$ selon l'invention est donc caractérisé en ce qu'il est constitué :

a) d'un châssis en matériau isolant électrique ;

b) de deux pinces conductrices solidaires du châssis équipées de moyens pour se fixer chacune sur un de ces conducteurs $A$ et $B$, chaque pince étant reliée à l'une des bornes d'un générateur de courant ;

c) de deux pointeaux métalliques solidaires du châssis et ayant des moyens pour se mettre en contact avec chacun des deux conducteurs $A$ et $B$, mais à l'intérieur de l'ensemble formé par $A$ et $B$ compris entre les liaisons des pinces $b$ avec $A$ et $B$ ;

d) d'un moyen de mesure de la différence de potentiel entre les deux pointeaux.

Le dispositif permet de mesurer la chute de tension entre deux points d'un circuit électrique constitué des deux conducteurs $A$ et $B$ et plus particulièrement la chute de tension provoquée par leur contact. Connaissant la résistance de chaque conducteur $A$ et $B$, on en déduit la résistance de leur contact. Les deux conducteurs $A$ et $B$ peuvent être identiques ou différents. Les pinces conductrices $b$ ont pour fonction d'amener le courant sur chaque conducteur, les moyens de fixation peuvent être des systèmes électromagnétiques, des vérins ou tout autre système permettant la fixation de la pince sur le conducteur $A$ ou $B$. Chaque pince étant reliée aux bornes d'un générateur de courant, on établit donc un circuit générateur/pince/conducteur A/contact $A$ avec B/conducteur B/pince/autre pôle de générateur. On peut ainsi simuler le fonctionnement réel des deux conducteurs $A$ et $B$ sous l'intensité réelle et mesurer la résistance de contact de $A$ avec $B$. Les deux pointeaux $c$ viennent s'appliquer sur chaque conducteur $A$ et $B$, soit par des vérins, soit par des dispositifs électromagnétiques ou par tout moyen équivalent. Le dispositif peut être utilisé pour mesurer la résistance de tous assemblages tels que des électrodes (cathodes ou anodes). Le dispositif peut être utilisé pour mesurer plusieurs résistances de contact en série. Par exemple, pour les assemblages cuivre/titane des anodes utiles dans le procédé d'électrolyse à mercure, il est plus simple de les mesurer par groupe de deux en série.

Si on trouve un défaut, il est nécessaire de démonter deux contacts et de les refaire mais cela est largement compensé par la vitesse et la fiabilité des mesures sur tous les autres assemblages.

Selon une forme préférée du dispositif de l'invention, les pinces $b$ sont métalliques de forme essentiellement hemicylindriques et disposées pour se fixer sur deux conducteurs cylindriques sous l'effet d'un vérin. Selon une autre forme préférée de l'invention, le châssis et les pinces sont disposées de telle sorte qu'elles s'adaptent sur deux conducteurs parallèles.

Avantageusement, les pointeaux s'adaptent sur les conducteurs $A$ et $B$ sous l'effet d'un vérin.

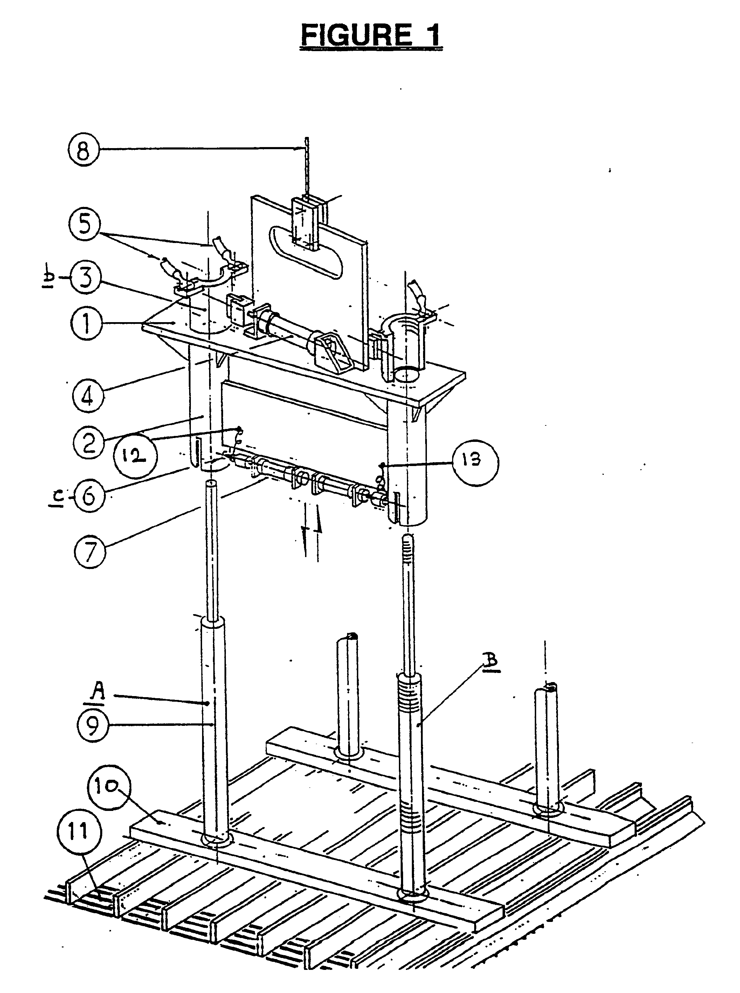

La figure 1 ci-jointe décrit une forme préférée d'undispositif de l'invention pour mesurer la résistance du circuit entre deux conducteurs cylindriques et parallèles. Pour en faciliter la compréhension, la description de la figure est faite en liaison avec son utilisation à la mesure d'un circuit constitué de deux tiges parallèles cylindriques de cuivre vissées dans une traverse en titane, ces éléments appartenant à une anode pour électrolyse.

Le dispositif comprend un châssis en matériau isolant électrique, matière plastique par exemple, qui sert de support aux divers éléments de l'appareil 1.

Les extrémités de ce châssis comportent deux cylindres creux 2 également en matériau isolant électrique, qui permettent à l'appareil de coulisser le long de deux tiges cylindriques en cuivre des anodes métalliques 9.

10 désigne une traverse en titane et 11 le réseau de fils en titane. L'anode est constituée de 9 10 et 11.

Deux pinces métalliques 3, en cuivre, fixées sur le châssis peuvent se déplacer horizontalement sous la poussée de deux vérins pneumatiques. Les pinces sont de forme préférentiellement hémicylindrique car elles viennent s'appliquer, sous la poussée des vérins 4, sur les tiges cylindriques, en cuivre des anodes.

Deux conducteurs électriques 5, en cuivre de préférence, reliés à l'un des pôles d'un générateur de courant électrique (par exemple un courant continu de plusieurs milliers d'ampères, sous différence de potentiel de quelques volts). L'autre pince est reliée à l'autre pôle.

Le déplacement des deux pointeaux métalliques à extrémités mobiles 6, est commandé par des vérins pneumatiques 7. Ces pointeaux, sous l'action de ces vérins, peuvent faire contact avec le circuit électrique juste en amont et juste en aval de la fraction de circuit où l'on veut mesurer la chute de potentiel.

Un voltmètre, non représenté, par exemple à affichage digital à 1/10e de mV près, est relié à la partie métallique de chacun des deux pointeaux en 12 et 13.

L'ensemble du dispositif décrit peut être suspendu à une potence par un câble à déplacement vertical 8, monté sur un chariot à déplacement horizontal. On obtient ainsi une grande maniabilité pour l'appareil objet de l'invention, lorsqu'il s'agit de réaliser un grand nombre de mesures répétitives sur les anodes métalliques.

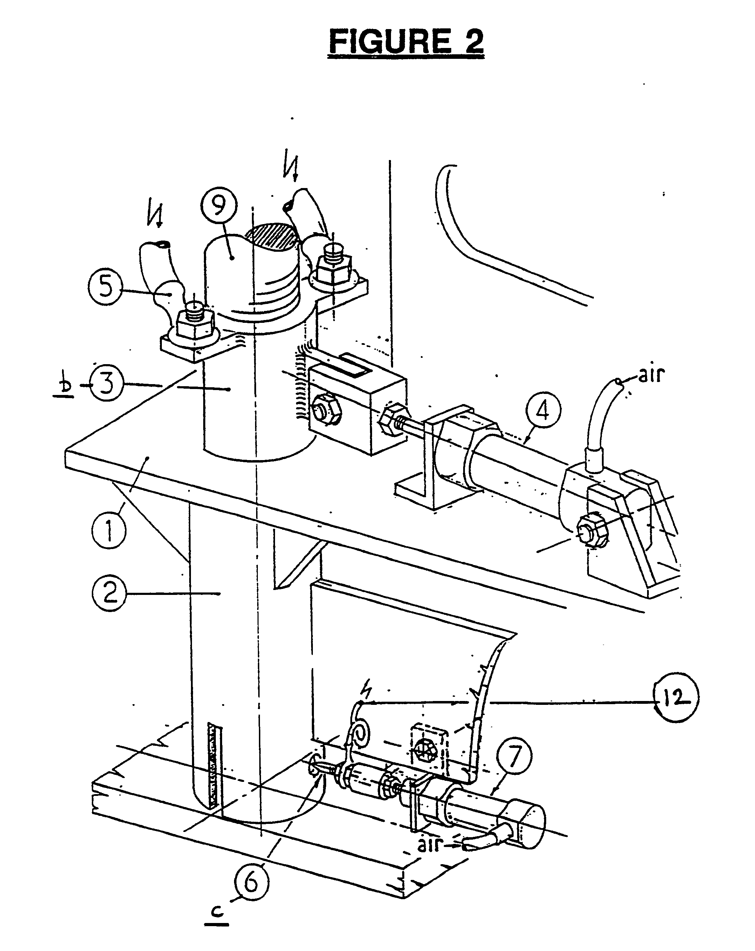

La figure 2 décrit des détails de la figure 1.

Une application particulièrement utile de ce dispositif est la mesure de la chute de potentiel électrique entre les diverses pièces métalliques constituant les anodes pour électrolyse de saumure de chlore de sodium. Le nombre des applications n'est pas limité à ce seul exemple.

Les anodes métalliques sont constituées de pièces de titane assemblées par soudage. Sur ces pièces en titane viennent se visser des tiges de cuivre, de forme cylindrique ; pour améliorer le contact cuivre-titane, on coule au préalable dans le taraudage titane un alliage à bas point de fusion (par exemple "alliage de Wood", PF = 60°C, composé de 50 % bismuth, 25 % plomb, 12,5 % cadmium, 12,5 % étain). Etant donné que le contact entre tige de cuivre et pièce en titane ne peut être observé de visu puisqu'il est noyé dans l'alliage de Wood, il est très intéressant d'utiliser l'appareil faisant l'objet de l'invention pour mesurer la qualité de ces contacts électriques.

Pour cela, l'appareil est adapté sur les tiges en cuivre de l'anode par simple coulissage dans les extrémités du châssis. Les deux pinces métalliques hémicylindriques, en cuivre, sont plaquées contre les tiges de cuivre par la commande des deux vérins pneumatiques à déplacement horizontal.

Les deux pinces en cuivre sont reliées électriquement à un générateur de courant continu qui permet de faire passer dans le circuit tiges Cu-pièces titane un courant continu (par exemple 2000 A sous 4 volts) comparable, en densité de courant, à celui qui est utilisé lors de l'électrolyse de saumure de NaCl.

Lorsque le circuit métallique ainsi constitué est parcouru par le courant électrique, les deux pointeaux sont alors appliqués contre les tiges en cuivre, en amont et en aval des contacts Cu-Ti grâce au déplacement de deux vérins pneumatiques. On mesure la chute de potentiel delta V entre les points choisis par simple lecture sur le voltmètre. Grâce à des étalonnages préalables, il est facile de déterminer la qualité des contacts électriques Cu-Ti, la valeur de la chute de tension mesurée s'affichant sur un écran digital. Plus la valeur mesurée est basse, environ 5 à 10 mV dans le cas présenté, meilleur est le contact électrique cuivre-titane.

Inversement une valeur supérieure à 20 mV permettra de détecter immédiatement un contact électrique de mauvaise qualité, qui nécessitera une réfection avant un nouveau test.

Cet appareil permet une mesure très rapide de cette chute de potentiel, par simple lecture du millivoltmètre ; ceci permet de ne faire passer le courant électrique dans le circuit que lors de la mesure, donc pendant un temps très bref. On évite ainsi tout échauffement des circuits électriques, on diminue la consommation de courant électrique et l'on peut réaliser ainsi un grand nombre de mesures en peu de temps.

Grâce à cet appareil, les anodes métalliques qui ont été testées favorablement pour la bonne qualité des contacts électriques, ont une durée de fonctionnement nettement accrue et peuvent rester en parfait état de marche durant plusieurs années, avec une consommation de courant minimale.

## Revendications

1. Dispositif de mesure du contact entre deux conducteurs A et B, caractérisé en ce qu'il est constitué :

a) d'un châssis en matériau isolant électrique ;

b) de deux pinces conductrices solidaires du châssis équipées de moyens pour se fixer chacune sur un de ces conducteurs A et B, chaque pince étant reliée à l'une des bornes d'un générateur de courant ;

c) de deux pointeaux métalliques solidaires du châssis et ayant des moyens pour se mettre en contact avec chacun des deux conducteurs A et B, mais à l'intérieur de l'ensemble formé par A et B comprise entre les liaisons des pinces b avec A et B ;

d) d'un moyen de mesure de la différence de potentiel entre les deux pointeaux.

2. Dispositif selon la revendication 1, caractérisé en ce que les pinces b sont métalliques, de forme essentiellement hémicylindriques et disposées pour se fixer sur deux conducteurs cylindriques sous l'effet du vérin.

3. Dispositif selon la revendication 1 ou 2, caractérisé en ce que les pinces sont disposées de telle sorte qu'elles s'adaptent sur deux conducteurs parallèles.

4. Dispositif selon l'une des revendications 1 à 3, caractérisé en ce que les pointeaux c s'adaptent sur les conducteurs sous l'effet d'un vérin.

5. Utilisation d'un dispositif selon l'une des revendications 1 à 4, pour mesurer la qualité des contacts entre les éléments d'une électrode.

# FIGURE 1

# FIGURE 2

Office européen
des brevets

**RAPPORT DE RECHERCHE EUROPEENNE**

Numero de la demande

EP 91 40 0359

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4 829 235 (ROBINSON et al.) * Colonne 2, lignes 32-57; colonne 4, lignes 27-68; figures 6-10 * | 1 | G 01 R 27/14 G 01 R 1/04 |
| A | | 3 | |
| A | US-A-3 996 514 (BROWN et al.) * Colonne 3, lignes 27-45; colonne 4, lignes 25-38; figures 2-6 * | 1,5 | |
| A | DE-A-2 352 430 (BERGNER) * Page 8, alinéa 1; figure 8 * | 2 | |
| A | US-A-2 954 521 (McKEE) * Colonne 1, lignes 50-71; figure 1 * | 2,4 | |

|  | | | DOMAINES TECHNIQUES RECHERCHES (Int. Cl.5) |
|---|---|---|---|
| | | | G 01 R H 01 R |

Le présent rapport a été établi pour toutes les revendications

| Lieu de la recherche | Date d'achèvement de la recherche | Examinateur |
|---|---|---|
| LA HAYE | 28-05-1991 | SINAPIUS G.H. |